# EUROPEAN PATENT APPLICATION

(11) **EP 4 429 108 A1**
(43) Date of publication of application: **11.09.2024**
(21) Application number: 21965968.7
(22) Date of filing: 01.12.2021
(51) Int. Cl.: H03H 9/02, H03H 3/02, H03H 9/205

(54) **BULK ACOUSTIC WAVE RESONATOR, FILTER AND ELECTRONIC DEVICE**

(71) Applicant: Huawei Technologies Co., Ltd., Shenzhen, Guangdong 518129 (CN)
(72) Inventor: ZHANG, Benfeng, Shenzhen, Guangdong 518129 (CN); HUANG, Yulin, Shenzhen, Guangdong 518129 (CN); LI, Xinyi, Shenzhen, Guangdong 518129 (CN); GAO, Zongzhi, Shenzhen, Guangdong 518129 (CN); HOU, Hangtian, Shenzhen, Guangdong 518129 (CN)
(74) Representative: Goddar, Heinz J.
(86) International application number: PCT/CN2021/134682
(87) International publication number: WO 2023/097531

(57) **Abstract**

Embodiments of this application provide a bulk acoustic wave resonator, a filter, and an electronic device, and relate to the field of semiconductor technologies, to improve performance of the filter. The bulk acoustic wave resonator includes a piezoelectric material layer, a first comb-shaped electrode, a second comb-shaped electrode, and at least one grid structure. The first comb-shaped electrode is disposed on the piezoelectric material layer, and the first comb-shaped electrode includes a first busbar and a plurality of first electrode fingers sequentially arranged along an extension direction of the first busbar. The second comb-shaped electrode is disposed on the piezoelectric material layer, and the second comb-shaped electrode includes a second busbar and a plurality of second electrode fingers sequentially arranged along an extension direction of the second busbar. The plurality of first electrode fingers and the plurality of second electrode fingers are arranged at spacings and do not contact each other. The grid structure is disposed at least between the first electrode finger and the second electrode finger, and is configured to suppress excitation of a high-order mode when an acoustic wave propagates along a first direction.

## Description

### TECHNICAL FIELD

This application relates to the field of semiconductor technologies, and in particular, to a bulk acoustic wave resonator, a filter, and an electronic device.

### BACKGROUND

With the development of mobile communication and users' increasing demands for communication speeds, more frequency bands are used in a mobile communication system. A filter is an important component in the mobile communication system.

An existing filter is a bottleneck for improving communication quality. With implementations of more communication modes and communication scenarios, it is challenging to improve performance of the filter. Currently, improving the performance of the filter is a research focus and difficulty for filter researchers.

### SUMMARY

Embodiments of this application provide a bulk acoustic wave resonator, a filter, and an electronic device, to improve performance of the filter.

To achieve the foregoing objective, this application uses the following technical solutions.

According to a first aspect, a bulk acoustic wave resonator is provided. The bulk acoustic wave resonator includes a piezoelectric material layer, a first comb-shaped electrode, a second comb-shaped electrode, and at least one grid structure. The first comb-shaped electrode is disposed on the piezoelectric material layer, and the first comb-shaped electrode includes a first busbar and a plurality of first electrode fingers sequentially arranged along an extension direction of the first busbar. The second comb-shaped electrode is disposed on the piezoelectric material layer, and the second comb-shaped electrode includes a second busbar and a plurality of second electrode fingers sequentially arranged along an extension direction of the second busbar. The plurality of first electrode fingers and the plurality of second electrode fingers are arranged at spacings and do not contact each other. The grid structure is disposed at least between the first electrode finger and the second electrode finger, and is configured to suppress excitation of a high-order mode when an acoustic wave propagates along a first direction. When the bulk acoustic wave resonator provided in this application operates, the acoustic wave mainly propagates in the piezoelectric material layer along the first direction. The first direction is a direction in which the plurality of first electrode fingers and the plurality of second electrode fingers are arranged at spacings. Because the bulk acoustic wave resonator includes the grid structure, the grid structure disposed between the first electrode finger and the second electrode finger can damage a periodicity of the acoustic wave propagating in the piezoelectric material layer along the first direction. Therefore, in an acoustic wave propagation process, the excitation of the high-order mode can be suppressed, and a spurious mode can further be suppressed or eliminated. This helps improve performance of the bulk acoustic wave resonator.

In a possible implementation of the first aspect, the at least one grid structure includes a plurality of grid structures arranged along the first direction. The first direction is a direction in which the plurality of first electrode fingers and the plurality of second electrode fingers are arranged at spacings. The plurality of grid structures can more effectively damage the periodicity of the acoustic wave propagating in the piezoelectric material layer along the first direction, so that the excitation of the high-order mode can be more significantly suppressed, and the spurious mode can be more significantly suppressed or eliminated in the acoustic wave propagation process.

In a possible implementation of the first aspect, widths of the plurality of grid structures along the first direction are not exactly the same. "Not exactly the same" may be that the widths of the plurality of grid structures along the first direction are different; or may be that widths of some grid structures along the first direction are the same, and widths of some grid structures along the first direction are different. When the widths of the plurality of grid structures along the first direction are not exactly the same, arrangement of the plurality of grid structures along the first direction is not periodic. Therefore, the periodicity of the acoustic wave propagating in the piezoelectric material layer along the first direction can be further damaged, the excitation of the high-order mode can be further suppressed, and the spurious mode can be further suppressed or eliminated.

In a possible implementation of the first aspect, the plurality of grid structures are disposed between at least one pair of the first electrode finger and the second electrode finger that are adjacent to each other, and the widths of the plurality of grid structures located between the first electrode finger and the second electrode finger that are adjacent to each other along the first direction satisfy one of the following conditions: the widths of the plurality of grid structures decrease first and then increase, or increase first and then decrease, or gradually increase in a direction approaching the first electrode finger from a middle of the first electrode finger and the second electrode finger, and gradually decrease in a direction of approaching the second electrode finger. Because the plurality of grid structures can damage the excitation of the high-order mode, the spurious mode can be effectively suppressed or eliminated. When the widths of the plurality of grid structures located between the first electrode finger and the second electrode finger that are adjacent to each other along the first direction satisfy the conditions, the plurality of grid structures between the first electrode finger and the second electrode finger that are adjacent to each other have a regularity. Therefore, an electromechanical coupling coefficient of the bulk acoustic wave resonator can be increased, and a difficulty in designing the plurality of grid structures can be simplified.

In a possible implementation of the first aspect, the plurality of grid structures are disposed between at least one pair of the first electrode finger and the second electrode finger that are adjacent to each other, and the plurality of grid structures located between the first electrode finger and the second electrode finger that are adjacent to each other include a first grid structure and a second grid structure that are alternately arranged, where a width of the first grid structure along the first direction is different from a width of the second grid structure along the first direction. Because the first grid structure and the second grid structure between the first electrode finger and the second electrode finger that are adjacent to each other are alternately arranged, the plurality of grid structures between the first electrode finger and the second electrode finger that are adjacent to each other have a regularity. Therefore, an electromechanical coupling coefficient of the bulk acoustic wave resonator can be increased, and a difficulty in designing the plurality of grid structures can be simplified.

In a possible implementation of the first aspect, the bulk acoustic wave resonator includes a plurality of same structural units arranged along the first direction, where the structural unit includes at least one first electrode finger, at least one second electrode finger, and the grid structure disposed at least between the first electrode finger and the second electrode finger. In the bulk acoustic wave resonator, the acoustic wave propagates along the first direction. Because the bulk acoustic wave resonator includes the plurality of same structural units arranged along the first direction, in other words, the structural units are repeatedly arranged along the first direction, the bulk acoustic wave resonator has a periodicity along the first direction. Therefore, an excitation intensity of a main mode of the acoustic wave propagation can be maximized, and a large electromechanical coupling coefficient can be obtained.

In a possible implementation of the first aspect, the bulk acoustic wave resonator includes a first structural unit and a second structural unit that are alternately arranged along the first direction. The first structural unit and the second structural unit each include at least one first electrode finger, at least one second electrode finger, and the grid structure disposed at least between the first electrode finger and the second electrode finger, where width distribution of the plurality of grid structures in the first structural unit along the first direction is different from width distribution of the plurality of grid structures in the second structural unit along the first direction; and/or, a spacing between the first electrode finger and the second electrode finger that are adjacent to each other in the first structural unit is different from a spacing between the first electrode finger and the second electrode finger that are adjacent to each other in the second structural unit. Because the bulk acoustic wave resonator includes the first structural unit and the second structural unit that are alternately arranged along the first direction, the bulk acoustic wave resonator has a periodicity along the first direction. Therefore, an excitation intensity of a main mode of the acoustic wave propagation can be maximized, and a large electromechanical coupling coefficient can be obtained. Based on this, to avoid a spurious mode caused by the same structural units, that is, the structural units that are repeatedly arranged in the acoustic wave resonator, the bulk acoustic wave resonator includes the first structural unit and the second structural unit, where the first structural unit is different from the second structural unit. In this way, the periodicity may be changed, so that an excitation intensity of a high-order spurious mode is reduced. Therefore, the high-order spurious mode can be suppressed or eliminated, and a degree of design freedom is enriched. Based on this, this design can not only obtain the large electromechanical coupling coefficient, but also suppress or eliminate the high-order spurious mode.

In a possible implementation of the first aspect, a range of a spacing p between the first electrode finger and the second electrode finger that are adjacent to each other is 2 µm≤p≤12.5 µm, and p is not equal to 3 µm and 5 µm. In this way, a regulation range of an electromechanical coupling coefficient of the bulk acoustic wave resonator may be larger, and the electromechanical coupling coefficient of the bulk acoustic wave resonator may be larger by modulating p, to satisfy requirements of some bulk acoustic wave resonators.

In a possible implementation of the first aspect, Euler angles (α, β, γ) of the piezoelectric material layer satisfy the following conditions: -10°<α<10°, -10°<γ<10°, and 18°<β<48°. In this case, the piezoelectric material layer has a large piezoelectric coefficient, so that the electromechanical coupling coefficient of the bulk acoustic wave resonator may be large.

In a possible implementation of the first aspect, a material of the piezoelectric material layer includes lithium niobate and/or lithium tantalate.

In a possible implementation of the first aspect, the bulk acoustic wave resonator further includes a dielectric layer. The dielectric layer is disposed on sides that are of the first comb-shaped electrode and the second comb-shaped electrode and that are away from the piezoelectric material layer, and the grid structure is disposed on a side that is of the dielectric layer and that is away from the piezoelectric material layer. When the bulk acoustic wave resonator includes the dielectric layer, the dielectric layer may be used for adjusting a resonance frequency of the bulk acoustic wave resonator or serve as a protection layer to protect the grid structure, the first comb-shaped electrode, and the second comb-shaped electrode. In addition, when the dielectric layer has a positive temperature coefficient, for example, when a material of the dielectric layer is SiO₂, the dielectric layer has the positive temperature coefficient, and the dielectric layer may further serve as a temperature compensation layer. For the bulk acoustic wave resonator, because the acoustic wave mainly propagates in the piezoelectric material layer, a shorter distance between the grid structure and the piezoelectric material layer indicates that the grid structure is more sensitive to impact of the acoustic wave, and the grid structure has higher modulation sensitivity. When the bulk acoustic wave resonator is designed, a position for disposing the dielectric layer may be selected as required.

In a possible implementation of the first aspect, the bulk acoustic wave resonator further includes a dielectric layer. The dielectric layer is disposed on sides that are of the first comb-shaped electrode, the second comb-shaped electrode, and the grid structure and that are away from the piezoelectric material layer, and covers the first comb-shaped electrode, the second comb-shaped electrode, and the grid structure. For details, refer to the foregoing descriptions about technical effects of the dielectric layer. Details are not described herein again.

In a possible implementation of the first aspect, surfaces of the first comb-shaped electrode and the second comb-shaped electrode that are close to the piezoelectric material layer and a surface of the grid structure that is close to the piezoelectric material layer are located on a same plane; or a side of the piezoelectric material layer that is close to the first comb-shaped electrode includes a groove, and the grid structure is located in the groove. When the grid structure is located in the groove, a distance between the grid structure and the piezoelectric material layer is the closest, and the grid structure is most sensitive to the impact of the acoustic wave.

In a possible implementation of the first aspect, the bulk acoustic wave resonator further includes a dielectric layer. The dielectric layer is disposed on sides that are of the first comb-shaped electrode and the second comb-shaped electrode and that are away from the piezoelectric material layer, and the grid structure is disposed in the dielectric layer. For details, refer to the foregoing descriptions about technical effects of the dielectric layer. Details are not described herein again.

In a possible implementation of the first aspect, the bulk acoustic wave resonator further includes a substrate. The substrate is disposed on a side that is of the piezoelectric material layer and that is away from the first comb-shaped electrode and the second comb-shaped electrode, and the substrate forms a ring.

The substrate is disposed in the bulk acoustic wave resonator. The substrate may be used for supporting the piezoelectric material layer, the first comb-shaped electrode, the second comb-shaped electrode, the grid structure, and the dielectric layer. Based on this, because the substrate forms a ring, a cavity structure may be formed. In the acoustic wave propagation process, the cavity structure may concentrate energy on the piezoelectric material layer, thereby increasing a quality factor of the bulk acoustic wave resonator. In addition, the substrate disposed in the bulk acoustic wave resonator may also implement process compatibility. For example, bonding between a bulk acoustic wave filter and another electronic component such as an IC (integrated circuit, integrated circuit) component may be implemented by using the substrate.

In a possible implementation of the first aspect, the bulk acoustic wave resonator further includes a support layer and a reflection layer that are disposed in a stacked manner. The reflection layer is disposed between the support layer and the piezoelectric material layer. The reflection layer includes a first acoustic impedance layer and a second acoustic impedance layer that are alternately disposed in a stacked manner, and acoustic impedance of the first acoustic impedance layer is different from acoustic impedance of the second acoustic impedance layer. Because the reflection layer may reflect the acoustic wave to the piezoelectric material layer, energy may be concentrated on the piezoelectric material layer in the acoustic wave propagation process. This can increase a quality factor of the bulk acoustic wave resonator. The support layer is used for supporting the reflection layer, the piezoelectric material layer, the first comb-shaped electrode, the second comb-shaped electrode, the grid structure, and the dielectric layer. A material of the support layer may include, for example, one or more of Si, SiC, diamond, sapphire, and AlN. Based on this, the support layer in the bulk acoustic wave resonator may also implement process compatibility. For example, bonding between a bulk acoustic wave filter and another electronic component such as an IC component may be implemented by using the support layer.

In a possible implementation of the first aspect, the grid structure is in a strip shape. An extension direction of the grid structure is the same as an extension direction of the first electrode finger and the second electrode finger. When the grid structure is in a strip shape, space occupied by the grid structure can be reduced. This helps dispose the plurality of grid structures between the first electrode finger and the second electrode finger.

According to a second aspect, a bulk acoustic wave resonator is provided. The bulk acoustic wave resonator includes a piezoelectric material layer, a first comb-shaped electrode, and a second comb-shaped electrode. The first comb-shaped electrode is disposed on the piezoelectric material layer, and the first comb-shaped electrode includes a first busbar and a plurality of first electrode fingers sequentially arranged along an extension direction of the first busbar. The second comb-shaped electrode is disposed on the piezoelectric material layer, and the second comb-shaped electrode includes a second busbar and a plurality of second electrode fingers sequentially arranged along an extension direction of the second busbar. The plurality of first electrode fingers and the plurality of second electrode fingers are arranged at spacings and do not contact each other. Euler angles (α, β, γ) of the piezoelectric material layer satisfy the following conditions: -10°<α<10°, -10°<γ<10°, and 18°<β<48°. In this case, the piezoelectric material layer has a large piezoelectric coefficient, so that an electromechanical coupling coefficient of the bulk acoustic wave resonator may be large.

In a possible implementation of the second aspect, the bulk acoustic wave resonator further includes at least one grid structure. The grid structure is disposed at least between the first electrode finger and the second electrode finger. For details, refer to related descriptions of the first aspect. Details are not described herein again.

In a possible implementation of the second aspect, the at least one grid structure includes a plurality of grid structures arranged along a first direction. The first direction is a direction in which the plurality of first electrode fingers and the plurality of second electrode fingers are arranged at spacings. For details, refer to related descriptions of the first aspect. Details are not described herein again.

According to a third aspect, a bulk acoustic wave resonator is provided. The bulk acoustic wave resonator includes a piezoelectric material layer, a first comb-shaped electrode, and a second comb-shaped electrode. The first comb-shaped electrode is disposed on the piezoelectric material layer, and the first comb-shaped electrode includes a first busbar and a plurality of first electrode fingers sequentially arranged along an extension direction of the first busbar. The second comb-shaped electrode is disposed on the piezoelectric material layer, and the second comb-shaped electrode includes a second busbar and a plurality of second electrode fingers sequentially arranged along an extension direction of the second busbar. The plurality of first electrode fingers and the plurality of second electrode fingers are arranged at spacings and do not contact each other. A range of a spacing p between the first electrode finger and the second electrode finger that are adjacent to each other is 2 µm≤p≤12.5 µm, and p is not equal to 3 µm and 5 µm. In this way, a regulation range of an electromechanical coupling coefficient of the bulk acoustic wave resonator may be larger, and the electromechanical coupling coefficient of the bulk acoustic wave resonator may be larger by modulating p, to satisfy requirements of some bulk acoustic wave resonators.

In a possible implementation of the third aspect, the bulk acoustic wave resonator further includes at least one grid structure. The grid structure is disposed at least between the first electrode finger and the second electrode finger. For details, refer to related descriptions of the first aspect. Details are not described herein again.

In a possible implementation of the third aspect, the at least one grid structure includes a plurality of grid structures arranged along a first direction. The first direction is a direction in which the plurality of first electrode fingers and the plurality of second electrode fingers are arranged at spacings. For details, refer to related descriptions of the first aspect. Details are not described herein again.

According to a fourth aspect, a bulk acoustic wave resonator is provided. The bulk acoustic wave resonator includes a piezoelectric material layer, a first comb-shaped electrode, a second comb-shaped electrode, and at least one grid structure. The first comb-shaped electrode is disposed on the piezoelectric material layer, and the first comb-shaped electrode includes a first busbar and a plurality of first electrode fingers sequentially arranged along an extension direction of the first busbar. The second comb-shaped electrode is disposed on the piezoelectric material layer, and the second comb-shaped electrode includes a second busbar and a plurality of second electrode fingers sequentially arranged along an extension direction of the second busbar. The plurality of first electrode fingers and the plurality of second electrode fingers are arranged at spacings and do not contact each other. The grid structure is disposed at least between the first electrode finger and the second electrode finger. The at least one grid structure includes a plurality of grid structures arranged along a first direction. The first direction is a direction in which the plurality of first electrode fingers and the plurality of second electrode fingers are arranged at spacings. Widths of the plurality of grid structures along the first direction are not exactly the same. For details, refer to related descriptions of the first aspect. Details are not described herein again.

According to a fifth aspect, a piezoelectric material is provided. Euler angles (α, β, γ) of the piezoelectric material satisfy the following conditions: -10°<α<10°, -10°<γ<10°, and 18°<β<48°. For details, refer to the foregoing related description of the piezoelectric material. Details are not described herein again.

In a possible implementation of the fifth aspect, the piezoelectric material includes lithium niobate and/or lithium tantalate.

According to a sixth aspect, a filter is provided. The filter includes a plurality of cascaded bulk acoustic wave resonators. The bulk acoustic wave resonator is the bulk acoustic wave resonator provided in the first aspect. The filter has a same technical effect as the bulk acoustic wave resonator provided in the first aspect. For details, refer to related descriptions of the first aspect. Details are not described herein again.

According to a seventh aspect, an electronic device is provided. The electronic device includes a filter, a processor, and a circuit board. Both the filter and the processor are disposed on the circuit board. The filter is the filter provided in the sixth aspect. The electronic device has a same technical effect as the bulk acoustic wave resonator provided in the first aspect. For details, refer to related descriptions of the first aspect. Details are not described herein again.

### BRIEF DESCRIPTION OF DRAWINGS

FIG. 1 is a diagram of a structure of a bulk acoustic wave resonator according to a related technology;
FIG. 2 is an admittance curve diagram corresponding to the bulk acoustic wave resonator shown in FIG. 1;
FIG. 3a is a diagram of a structure of a bulk acoustic wave resonator according to an embodiment of this application;
FIG. 3b is a schematic cross-sectional view of an AA direction in FIG. 3a;
FIG. 4 is an admittance curve diagram corresponding to the bulk acoustic wave resonator shown in FIG. 3a;
FIG. 5a is a diagram of a structure of a bulk acoustic wave resonator according to another embodiment of this application;
FIG. 5b is a diagram of a structure of a bulk acoustic wave resonator according to still another embodiment of this application;
FIG. 5c is a diagram of a structure of a bulk acoustic wave resonator according to still another embodiment of this application;
FIG. 6 is a diagram of a structure of a bulk acoustic wave resonator according to still another embodiment of this application;
FIG. 7a is a diagram of a structure of a bulk acoustic wave resonator according to still another embodiment of this application;
FIG. 7b is a diagram of a structure of a bulk acoustic wave resonator according to still another embodiment of this application;
FIG. 7c is a diagram of a structure of a bulk acoustic wave resonator according to still another embodiment of this application;
FIG. 8 is a diagram of a structure of a bulk acoustic wave resonator according to still another embodiment of this application;
FIG. 9 is a diagram of a structure of a bulk acoustic wave resonator according to still another embodiment of this application;
FIG. 10 is a diagram of a structure of a bulk acoustic wave resonator according to still another embodiment of this application;
FIG. 11 is a diagram of a structure of a bulk acoustic wave resonator according to still another embodiment of this application;
FIG. 12 is a diagram of a structure of a bulk acoustic wave resonator according to still another embodiment of this application;
FIG. 13 is a diagram of a structure of a bulk acoustic wave resonator according to still another embodiment of this application;
FIG. 14 is a diagram of a structure of a piezoelectric material layer according to an embodiment of this application;
FIG. 15 is a diagram of a structure of a bulk acoustic wave resonator according to still another embodiment of this application;
FIG. 16 is a diagram of a structure of a bulk acoustic wave resonator according to still another embodiment of this application;
FIG. 17 is a schematic top view of a structure of a support layer according to an embodiment of this application;
FIG. 18 is a diagram of a structure of a bulk acoustic wave resonator according to still another embodiment of this application;
FIG. 19 is a diagram of a structure of a bulk acoustic wave resonator according to still another embodiment of this application;
FIG. 20 is a diagram of a structure of a bulk acoustic wave resonator according to still another embodiment of this application;
FIG. 21 is a diagram of a structure of a bulk acoustic wave resonator according to still another embodiment of this application;
FIG. 22 is an admittance curve diagram corresponding to the bulk acoustic wave resonator shown in FIG. 21;
FIG. 23a is a curve chart of a variation relationship between a piezoelectric coefficient e₁₅ and β under different α and γ according to an embodiment of this application;
FIG. 23b is a partial enlarged view of FIG. 23a; and
FIG. 24 is an admittance curve diagram corresponding to different spacings p in the bulk acoustic wave resonator shown in FIG. 21.

### Reference numerals:

10-Bulk acoustic wave resonator; 101-Piezoelectric material layer; 103-Grid structure; 104-Dielectric layer; 105-Substrate; 106-Support layer; 107-Reflection layer; 200-Structural unit; 201-First structural unit; 202-Second structural unit; 1021-First comb-shaped electrode; 1021a-First busbar; 1021b-First electrode finger; 1022-Second comb-shaped electrode; 1022a-Second busbar; 1022b-Second electrode finger; 1071-First acoustic impedance layer; and 1072-Second acoustic impedance layer.

### DESCRIPTION OF EMBODIMENTS

The following describes technical solutions in embodiments of this application with reference to the accompanying drawings in embodiments of this application. It is clear that the described embodiments are merely a part rather than all of embodiments of this application.

The following terms "first" and "second" are merely used for ease of description, and shall not be construed as an indication or implication of relative importance or an implicit indication of a quantity of indicated technical features. Therefore, a feature limited by "first", "second", and the like may explicitly or implicitly include one or more features. In descriptions of this application, unless otherwise stated, "a plurality of" means two or more than two.

In addition, in embodiments of this application, the word "example" or "for example" is used to indicate giving an example, an illustration, or a description. Any embodiment or design scheme described as an "example" or "for example" in embodiments of this application should not be explained as being more preferred or having more advantages than another embodiment or design scheme. Exactly, use of the term such as "example" or "for example" is intended to present a relative concept in a specific manner.

In embodiments of this application, the term "and/or" describes an association relationship between associated objects, and may indicate that three relationships exist. For example, A and/or B may indicate the following cases: Only A exists, both A and B exist, and only B exists, where A and B may be singular or plural. The character "/" generally indicates an "or" relationship between the associated objects.

An embodiment of this application provides a filter. The filter may be, for example, a low-pass filter, a high-pass filter, a band-pass filter, a band-rejection filter, or an active filter.

The filter provided in this embodiment of this application includes a plurality of cascaded bulk acoustic wave (bulk acoustic wave, BAW) resonators. The plurality of bulk acoustic wave resonators may be cascaded together in a series and/or parallel manner.

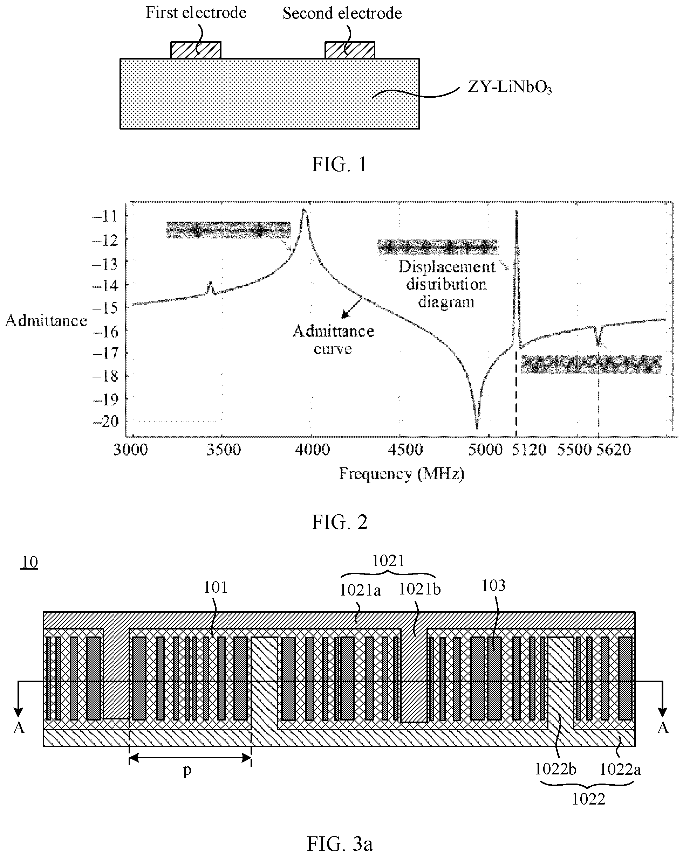

A Ladder filter is a commonly used topology structure in current filters, which includes cascaded resonators in a series and/or parallel manner with different resonance frequencies. This type of filter has advantages of a small passband insertion loss, high out-of-band steepness, and strong power tolerance. Performance of the filter is closely related to performance of the resonator. The bulk acoustic wave resonator includes a film bulk acoustic resonator (film bulk acoustic resonator, FBAR), a solidly mounted resonator (solidly mounted resonator, SMR), or a Lamb (Lamb) wave resonator. The Lamb wave resonator is used as an example. A structure of the Lamb wave resonator provided in a related technology may be, for example, as shown in FIG. 1, including a ZY-LiNbO₃ (lithium niobate) piezoelectric sheet, and a first electrode and a second electrode disposed on the ZY-LiNbO₃ piezoelectric sheet. After the bulk acoustic wave resonator in the filter is prepared, an admittance (admittance) curve of the bulk acoustic wave resonator is generally obtained through testing by using an impedance analyzer. The admittance curve may represent various indicators of the bulk acoustic wave resonator.

However, in addition to a main mode, the admittance curve of the relevant bulk acoustic wave resonator further includes a spurious mode. FIG. 2 is an admittance curve corresponding to the bulk acoustic wave resonator shown in FIG. 1. In the admittance curve shown in FIG. 2, spurious modes exist at frequencies of 5120 MHz and 5620 MHz. FIG. 2 further shows a distribution diagram of displacement of the main mode and the spurious modes. From the displacement distribution, it may be determined that these spurious modes are caused by a high-order mode formed by an acoustic wave in a main propagation direction. However, the spurious modes seriously affect the performance of the bulk acoustic wave resonator, and further affect the performance of the filter. To resolve a problem that the admittance curve of the existing bulk acoustic wave resonator further includes the spurious modes in addition to the main mode, and the spurious modes severely affect the performance of the bulk acoustic wave resonator and further affects the performance of the filter, an embodiment of this application further provides a bulk acoustic wave resonator, and the bulk acoustic wave resonator may be used in the foregoing filter. The following describes an example of a structure of the bulk acoustic wave resonator by using several specific embodiments.

### Embodiment 1

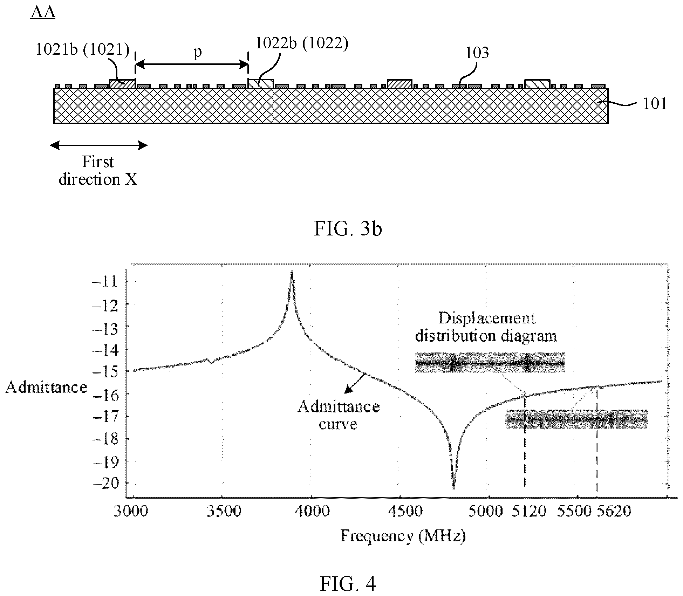

In Embodiment 1, FIG. 3a is a schematic top view of a structure of a bulk acoustic wave resonator 10, and FIG. 3b is a schematic cross-sectional view of an AA direction in FIG. 3a. Refer to FIG. 3a and FIG. 3b. The bulk acoustic wave resonator 10 includes a piezoelectric material layer 101, a first comb-shaped electrode 1021, a second comb-shaped electrode 1022, and at least one grid structure 103.

For example, a material of the piezoelectric material layer 101 may include one or more of LiNbO₃ (lithium niobate), LiTaO₃ (lithium tantalate), and the like.

It should be understood that a function of the piezoelectric material layer 101 is to generate inverse piezoelectric effect by converting electric energy into mechanical energy in a form of an acoustic wave. The resonator provided in this embodiment of this application is the bulk acoustic wave resonator. For the bulk acoustic wave resonator, an acoustic wave mainly propagates in the piezoelectric material layer 101. Compared with a thickness of a piezoelectric material layer in a surface acoustic wave (surface acoustic wave, SAW) resonator, a thickness of the piezoelectric material layer 101 in the bulk acoustic wave resonator is smaller. In this embodiment of this application, the thickness of the piezoelectric material layer 101 may be, for example, (0, 2] µm. To be specific, the thickness of the piezoelectric material layer 101 is greater than 0 and less than or equal to 2 µm.

The first comb-shaped electrode (interdigital transducer, IDT) 1021 is disposed on the piezoelectric material layer 101. The first comb-shaped electrode 1021 includes a first busbar 1021a and a plurality of first electrode fingers (IDT electrodes) 1021b sequentially arranged along an extension direction of the first busbar (busbar) 1021a. The plurality of first electrode fingers (which may also be referred to as first comb metal strips) 1021b are all electrically connected to the first busbar 1021a, and the plurality of first electrode fingers 1021b do not contact each other.

A quantity of the plurality of first electrode fingers 1021b in the first comb-shaped electrode 1021 is not limited herein. The first comb-shaped electrode 1021 may include two or more first electrode fingers 1021b. When the first comb-shaped electrode 1021 includes more than two first electrode fingers 1021b, the first electrode fingers 1021b may be arranged at an equal spacing, or may be arranged at an unequal spacing, to be specific, a spacing between at least one group of adjacent first electrode fingers 1021b is different from a spacing between another group of adjacent first electrode fingers 1021b.

The second comb-shaped electrode 1022 is disposed on the piezoelectric material layer 101. The second comb-shaped electrode 1022 includes a second busbar 1022a and a plurality of second electrode fingers (which may also be referred to as second comb metal strips) 1022b sequentially arranged along an extension direction of the second busbar 1022a. The plurality of second electrode fingers 1022b are all electrically connected to the second busbar 1022a, and the plurality of second electrode fingers 1022b do not contact each other.

Similarly, a quantity of the plurality of second electrode fingers 1022b in the second comb-shaped electrode 1022 is not limited. The second comb-shaped electrode 1022 may include two or more second electrode fingers 1022b. When the second comb-shaped electrode 1022 includes more than two second electrode fingers 1022b, the second electrode fingers 1022b may be arranged at an equal spacing, or may be arranged at an unequal spacing, to be specific, a spacing between at least one group of adjacent second electrode fingers 1022b is different from a spacing between another group of adjacent second electrode fingers 1022b.

It should be noted that the first comb-shaped electrode 1021 and the second comb-shaped electrode 1022 may be manufactured at a same time; or the first comb-shaped electrode 1021 may be manufactured before the second comb-shaped electrode 1022; or the second comb-shaped electrode 1022 may be manufactured before the first comb-shaped electrode 1021.

The plurality of first electrode fingers 1021b in the first comb-shaped electrode 1021 and the plurality of second electrode fingers 1022b in the second comb-shaped electrode 1022 are arranged at spacings and do not contact each other.

It should be understood that, the plurality of first electrode fingers 1021b and the plurality of second electrode fingers 1022b may be arranged at an equal spacing, or may be arranged at an unequal spacing, to be specific, a spacing between at least one group of the first electrode finger 1021b and the second electrode finger 1022b that are adjacent to each other is different from a spacing between another group of the first electrode finger 1021b and the second electrode finger 1022b that are adjacent to each other. "A spacing p between the first electrode finger 1021b and the second electrode finger 1022b that are adjacent to each other" may be as shown in FIG. 3a, and is a spacing between a side of the first electrode finger 1021b close to the second electrode finger 1022b and a side of the second electrode finger 1022b close to the first electrode finger 1021b.

Based on this, the at least one grid structure 103 may include one grid structure 103, or may include a plurality of grid structures 103 arranged along a first direction, where the first direction is a direction in which the plurality of first electrode fingers and the plurality of second electrode fingers are arranged at spacings.

The at least one grid structure 103 is disposed at least between the first electrode finger 1021b and the second electrode finger 1022b. The grid structure 103 is configured to suppress excitation of a high-order mode when the acoustic wave propagates along the first direction. It should be noted that, when the bulk acoustic wave resonator 10 includes one grid structure 103, the grid structure 103 is disposed between the first electrode finger 1021b and the second electrode finger 1022b. When the bulk acoustic wave resonator 10 includes the plurality of grid structures 103, the plurality of grid structures 103 may all be disposed between the first electrode finger 1021b and the second electrode finger 1022b; or some grid structures 103 may be disposed between the first electrode finger 1021b and the second electrode finger 1022b, and some grid structures 103 are disposed outside the plurality of first electrode fingers 1021b and the plurality of second electrode fingers 1022b.

In addition, in some examples, a material of the grid structure 103 is a conductive material, and the conductive material may be, for example, one or more of Al (aluminum), Mo (molybdenum), W (tungsten), Ru (ruthenium), Cu (copper), and Pt (platinum). In some other examples, a material of the grid structure 103 is an insulating material, and the insulating material may include, for example, one or more of silicon oxide (SiOₓ), silicon nitride (SiNₓ), silicon oxynitride (SiOₓN_{y}), and aluminum oxide (Al₂O₃).

When the bulk acoustic wave resonator 10 provided in this embodiment of this application operates, the acoustic wave mainly propagates in the piezoelectric material layer 101 along a first direction X. The first direction X is a direction in which the plurality of first electrode fingers 1021b and the plurality of second electrode fingers 1022b are arranged at spacings. Because the bulk acoustic wave resonator 10 includes the grid structure 103, the grid structure 103 disposed between the first electrode finger 1021b and the second electrode finger 1022b can damage a periodicity of the acoustic wave propagating in the piezoelectric material layer 101 along the first direction. Therefore, in an acoustic wave propagation process, the excitation of the high-order mode can be suppressed, and a spurious mode can further be suppressed or eliminated. This helps improve performance of the bulk acoustic wave resonator. When the at least one grid structure 103 includes the plurality of grid structures 103 arranged along the first direction, the plurality of grid structures 103 can more effectively damage the periodicity of the acoustic wave propagating in the piezoelectric material layer 101 along the first direction X. Therefore, in the acoustic wave propagation process, the excitation of the high-order mode can be more significantly suppressed, and the spurious mode can be more significantly suppressed or eliminated.

FIG. 4 shows an admittance curve corresponding to the bulk acoustic wave resonator shown in FIG. 3a. Compared with FIG. 4 and FIG. 2, it can be learned that the admittance curve in FIG. 4 has no spurious mode except the main mode. FIG. 4 further shows a displacement field distribution diagram at frequencies of 5120 MHz and 5620 MHz. It can be seen from a comparison between a displacement field distribution diagram at frequencies of 5120 MHz and 5620 MHz in FIG. 2 and the displacement field distribution diagram at frequencies of 5120 MHz and 5620 MHz in FIG. 4 that, in the displacement field distribution diagram shown in FIG. 4, vibrations in the main mode occur between electrodes, and in the displacement field distribution diagram shown in FIG. 2, vibrations in a third order mode and a high-order mode occur between electrodes. Therefore, it is proved again that the high-order mode is suppressed and the spurious mode can be suppressed or eliminated.

In some examples, the grid structure 103 may be in a strip shape. An extension direction of the grid structure 103 is the same as an extension direction of the first electrode finger 1021b and the second electrode finger 1022b.

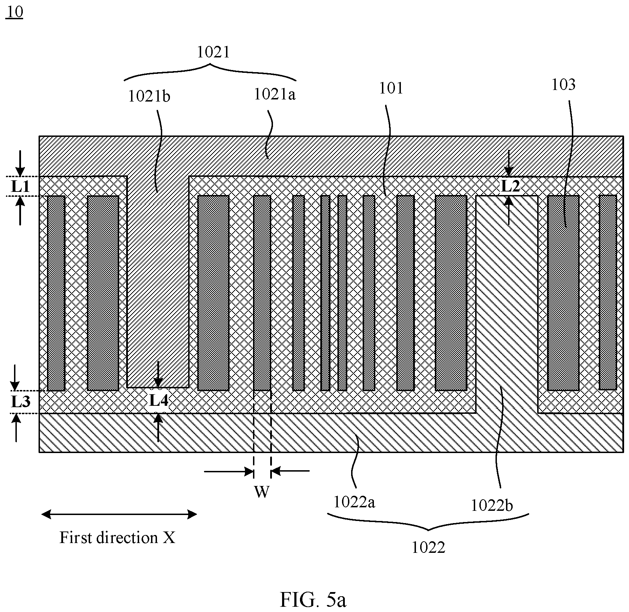

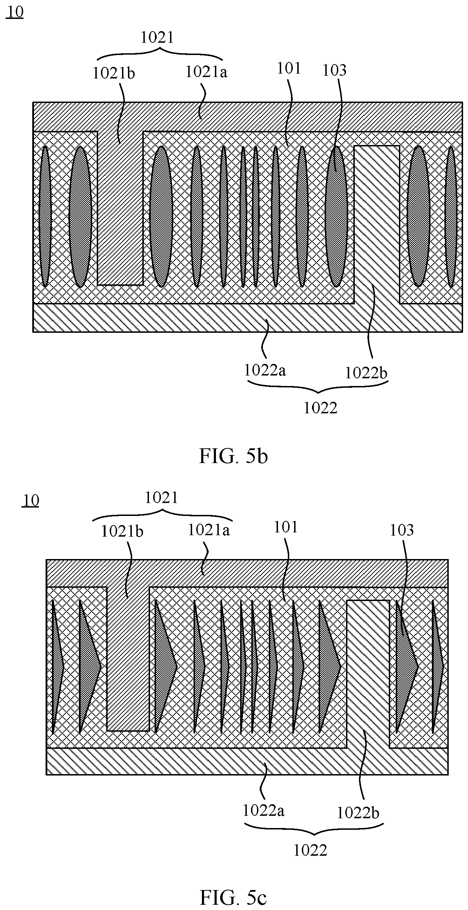

When the grid structure 103 is in a strip shape, for example, as shown in FIG. 5a, an orthographic projection of the grid structure 103 on the piezoelectric material layer 101 may be in a rectangle shape. In this way, a manufacturing process of the grid structure 103 can be simplified. For another example, as shown in FIG. 5b, a projection of the grid structure 103 on the piezoelectric material layer 101 is in an ellipse shape. For another example, as shown in FIG. 5c, a projection of the grid structure 103 on the piezoelectric material layer 101 is in a triangle shape. It should be understood that, when the grid structure 103 is in the strip shape, the orthographic projection of the grid structure 103 on the piezoelectric material layer 101 includes but is not limited to the rectangle shape, the ellipse shape, or the triangle shape, and may be in another regular or irregular shape.

It may be understood that, when the grid structure 103 is in the strip shape, space occupied by the grid structure 103 can be reduced. This helps dispose the plurality of grid structures 103 between the first electrode finger 1021b and the second electrode finger 1022b.

It should be noted that, when the grid structure 103 is in the strip shape, the extension direction of the grid structure 103 may further intersect with, for example, may be perpendicular to the extension direction of the first electrode finger 1021b and the second electrode finger 1022b.

Based on this, when the grid structure 103 is in the strip shape, a spacing L1 between the grid structure 103 and the first busbar 1021a and a spacing L2 between the second electrode finger 1022b and the first busbar 1021a may be that L1 is greater than L2, or L1 is equal to L2, or L1 is less than L2. A spacing L3 between the grid structure 103 and the second busbar 1022a and a spacing L4 between the first electrode finger 1021b and the second busbar 1022a may be that L3 is greater than L4, or L3 is equal to L4, or L3 is less than L4.

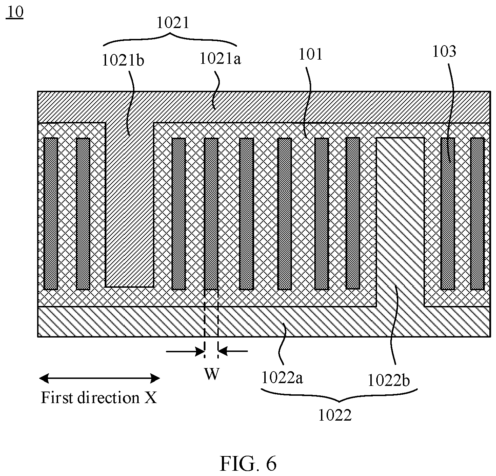

When the bulk acoustic wave resonator 10 includes the plurality of grid structures 103, in some examples, as shown in FIG. 6, widths W of the plurality of grid structures 103 along the first direction X are the same.

It should be noted that, for any grid structure 103, if widths of the grid structure 103 at different positions along the first direction X are not exactly the same, the width W of the grid structure 103 along the first direction X may be considered as a maximum width of the grid structure 103 along the first direction X.

In some other examples, widths of the plurality of grid structures 103 along the first direction X are not exactly the same. "Not exactly the same" may be that the widths of the plurality of grid structures 103 along the first direction X are different; or may be that widths of some grid structures 103 along the first direction X are the same, and widths of some grid structures 103 along the first direction X are different.

When the widths of the plurality of grid structures 103 along the first direction X are not exactly the same, arrangement of the plurality of grid structures along the first direction X is not periodic. Therefore, the periodicity of the acoustic wave propagating in the piezoelectric material layer 101 along the first direction X can be further damaged, the excitation of the high-order mode can be further suppressed, and the spurious mode can be further suppressed or eliminated.

When the widths of the plurality of grid structures 103 along the first direction X are not exactly the same, and the plurality of grid structures 103 are disposed between the first electrode finger 1021b and the second electrode finger 1022b that are adjacent to each other, the widths of the plurality of grid structures 103 between at least one pair of the first electrode finger 1021b and the second electrode finger 1022b that are adjacent to each other along the first direction X may, for example, satisfy one of the following conditions.

First condition: As shown in FIG. 5a, the widths W of the plurality of grid structures 103 located between the first electrode finger 1021b and the second electrode finger 1022b that are adjacent to each other decrease first and then increase along the first direction X. In other words, the widths W of the plurality of grid structures 103 gradually increase in a direction of approaching the first electrode finger 1021b and the second electrode finger 1022b from a middle of the first electrode finger 1021b and the second electrode finger 1022b.

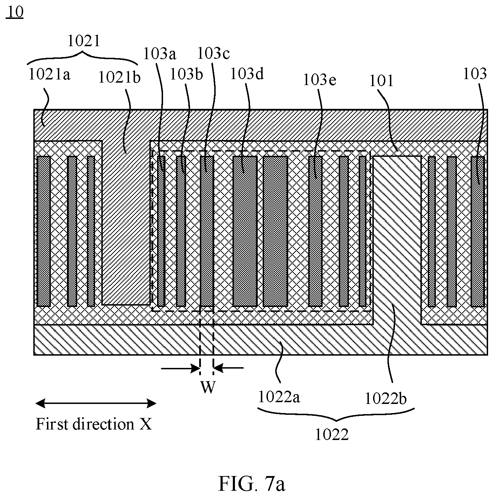

Second condition: As shown in FIG. 7a, the widths W of the plurality of grid structures 103 located between the first electrode finger 1021b and the second electrode finger 1022b that are adjacent to each other increase first and then decrease along the first direction X. In other words, the widths W of the plurality of grid structures 103 gradually decrease in a direction of approaching the first electrode finger 1021b and the second electrode finger 1022b from a middle of the first electrode finger 1021b and the second electrode finger 1022b.

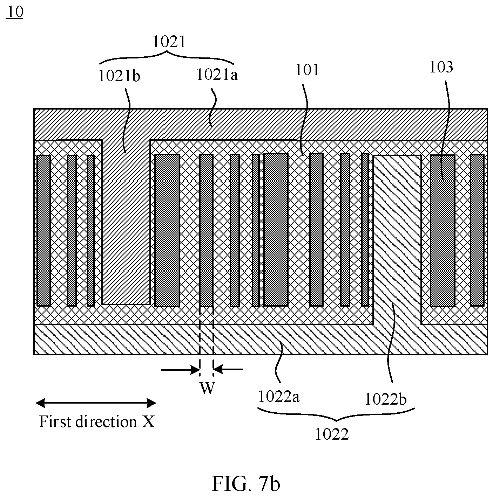

Third condition: As shown in FIG. 7b, the widths W of the plurality of grid structures 103 located between the first electrode finger 1021b and the second electrode finger 1022b that are adjacent to each other gradually increase in a direction approaching the first electrode finger 1021b from a middle of the first electrode finger 1021b and the second electrode finger 1022b, and gradually decrease in a direction of approaching the second electrode finger 1022b.

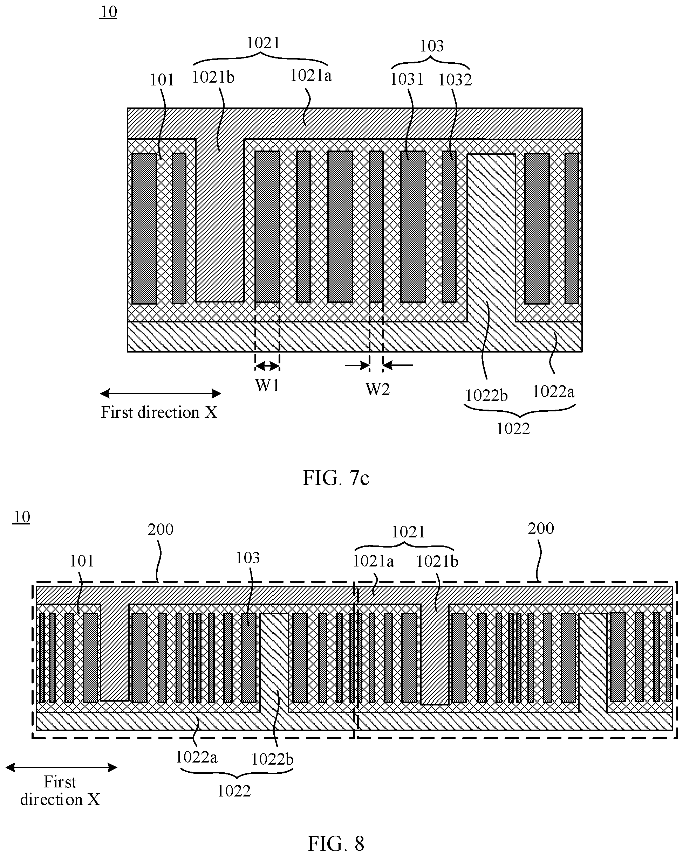

Fourth condition: As shown in FIG. 7c, the plurality of grid structures 103 located between the first electrode finger 1021b and the second electrode finger 1022b that are adjacent to each other include a first grid structure 1031 and a second grid structure 1032 that are alternately arranged. A width W1 of the first grid structure 1031 along the first direction X is different from a width W2 of the second grid structure 1032 along the first direction X.

It should be noted that, "the plurality of grid structures 103" in "the plurality of grid structures 103 between the first electrode finger 1021b and the second electrode finger 1022b that are adjacent to each other" may be all grid structures 103 between the first electrode finger 1021b and the second electrode finger 1022b that are adjacent to each other, or may be some grid structures 103 between the first electrode finger 1021b and the second electrode finger 1022b that are adjacent to each other. When the plurality of grid structures 103 are some grid structures 103 between the first electrode finger 1021b and the second electrode finger 1022b that are adjacent to each other, the "some grid structures 103" may be consecutively disposed, or may be inconsecutively disposed. In other words, another grid structure 103 is disposed between the "some grid structures 103".

For example, refer to FIG. 7a. The plurality of grid structures 103 between the first electrode finger 1021b and the second electrode finger 1022b that are adjacent to each other may be all grid structures 103 that are indicated by a dashed box and that are located between the first electrode finger 1021b and the second electrode finger 1022b that are adjacent to each other. For another example, refer to FIG. 7a. The plurality of grid structures 103 between the first electrode finger 1021b and the second electrode finger 1022b that are adjacent to each other may alternatively be a grid structure 103a, a grid structure 103b, a grid structure 103c, and a grid structure 103d. For another example, refer to FIG. 7a. The plurality of grid structures 103 between the first electrode finger 1021b and the second electrode finger 1022b that are adjacent to each other may alternatively be a grid structure 103a, a grid structure 103c, a grid structure 103d, and a grid structure 103e.

When the plurality of grid structures 103 between the first electrode finger 1021b and the second electrode finger 1022b that are adjacent to each other satisfy the first, second, third, or fourth condition described above, the plurality of grid structures 103 can damage the excitation of the high-order mode. Therefore, the spurious mode can be effectively suppressed or eliminated. In addition, when the plurality of grid structures 103 between the first electrode finger 1021b and the second electrode finger 1022b that are adjacent to each other satisfy the first, second, third, or fourth condition, the plurality of grid structures 103 between the first electrode finger 1021b and the second electrode finger 1022b that are adjacent to each other have a regularity. Therefore, an electromechanical coupling coefficient of the main mode of the bulk acoustic wave resonator 10 can be increased, and a difficulty in designing the plurality of grid structures 103 can be simplified.

Based on the foregoing descriptions, it should be noted that, when the bulk acoustic wave resonator 10 includes a plurality of pairs of first electrode fingers 1021b and second electrode fingers 1022b that are adjacent to each other, and the plurality of grid structures 103 are disposed between the first electrode fingers 1021b and second electrode fingers 1022b that are adjacent to each other, in some examples, the plurality of grid structures 103 between each pair of the first electrode finger 1021b and the second electrode finger 1022b that are adjacent to each other are distributed in a same width along the first direction X. For example, as shown in FIG. 8, widths of the plurality of grid structures 103 between each pair of the first electrode finger 1021b and the second electrode finger 1022b that are adjacent to each other along the first direction X satisfy the first condition. For another example, widths of the plurality of grid structures 103 between each pair of the first electrode finger 1021b and the second electrode finger 1022b that are adjacent to each other along the first direction X satisfy the second condition.

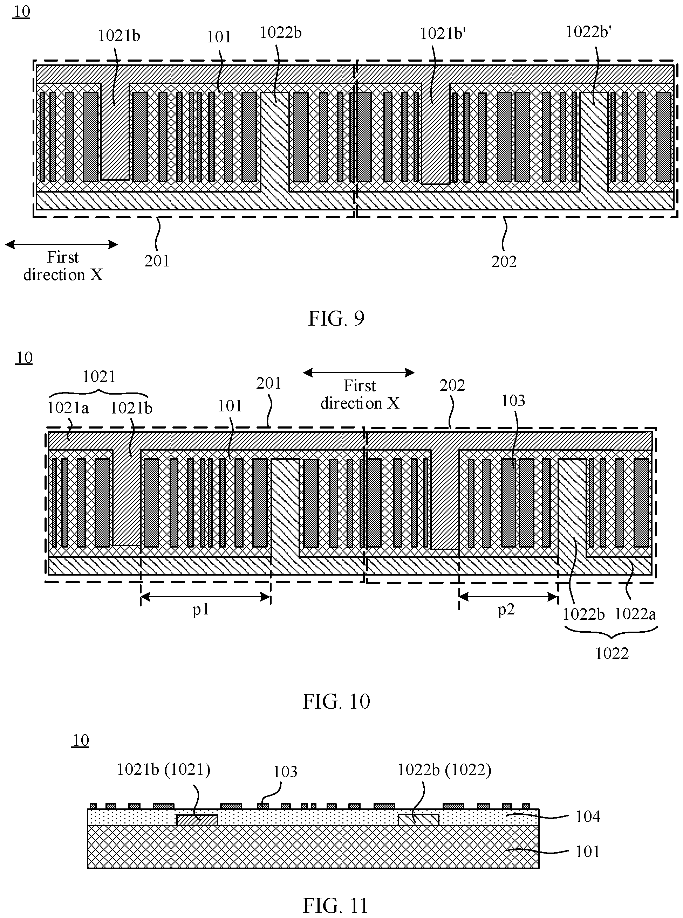

In some other examples, width distribution of the plurality of grid structures 103 between the at least one pair of the first electrode finger 1021b and the second electrode finger 1022b that are adjacent to each other along the first direction X is different from width distribution of the plurality of grid structures 103 between another pair of the first electrode finger 1021b and the second electrode finger 1022b that are adjacent to each other along the first direction X. For example, as shown in FIG. 9, widths of the plurality of grid structures 103 between the first electrode finger 1021b and the second electrode finger 1022b that are adjacent to each other along the first direction X satisfy the first condition. Widths of the plurality of grid structures 103 between a first electrode finger 1021b' and the second electrode finger 1022b that are adjacent to each other along the first direction X satisfy the second condition. Widths of the plurality of grid structures 103 between the first electrode finger 1021b' and a second electrode finger 1022b' that are adjacent to each other along the first direction X satisfy the third condition.

It should be understood that, in design of the bulk acoustic wave resonator 10, to obtain a large electromechanical coupling coefficient, the bulk acoustic wave resonator 10 includes same structural units. The following provides two design schemes of the bulk acoustic wave resonator 10 as an example.

First scheme: As shown in FIG. 8, the bulk acoustic wave resonator 10 includes a plurality of same structural units 200 arranged along the first direction X. In other words, the structural units 200 are repeatedly arranged along the first direction X. The structural units 200 include at least one first electrode finger 1021b, at least one second electrode finger 1022b, and the grid structure 103 disposed at least between the first electrode finger 1021b and the second electrode finger 1022b.

When the plurality of grid structures 103 are disposed between the first electrode finger 1021b and the second electrode finger 1022b that are adjacent to each other, for descriptions of width distribution of the plurality of grid structures 103 along the first direction X, refer to the foregoing descriptions. Details are not described herein again.

In addition, a quantity of first electrode fingers 1021b and second electrode fingers 1022b disposed in the structural unit 200 is not limited, and may be set as required. In addition, the quantity of first electrode fingers 1021b disposed in the structural unit 200 may be the same as or different from the quantity of second electrode fingers 1022b disposed in the structural unit 200.

It should be noted that, in addition to the grid structure 103 disposed between the first electrode finger 1021b and the second electrode finger 1022b, in some examples, as shown in FIG. 8, the structural unit 200 may further include the grid structure 103 disposed on an outer side of the first electrode finger 1021b and/or the second electrode finger 1022b that are/is on an outermost side of the structural unit 200.

In addition, a quantity of structural units 200 included in the bulk acoustic wave resonator 10 may be set as required.

In the bulk acoustic wave resonator 10, the acoustic wave propagates along the first direction X. Because the bulk acoustic wave resonator 10 includes the plurality of same structural units 200 arranged along the first direction X, in other words, the structural units 200 are repeatedly arranged along the first direction X, the bulk acoustic wave resonator 10 has a periodicity along the first direction X. Therefore, an excitation intensity of the main mode of the acoustic wave propagation can be maximized, and the large electromechanical coupling coefficient can be obtained.

Second scheme: As shown in FIG. 9, the bulk acoustic wave resonator 10 includes a first structural unit 201 and a second structural unit 202 that are alternately arranged along the first direction X. The first structural unit 201 and the second structural unit 202 each include at least one first electrode finger 1021b, at least one second electrode finger 1022b, and the grid structure 103 disposed at least between the first electrode finger 1021b and the second electrode finger 1022b. In addition, the first structural unit 201 is different from the second structural unit 202.

For descriptions of the first structural unit 201 and the second structural unit 202, refer to related descriptions of the foregoing structural unit 200, and details are not described herein again.

The first structural unit 201 is different from the second structural unit 202. As shown in FIG. 9, width distribution of the plurality of grid structures 103 in the first structural unit 201 along the first direction is different from width distribution of the plurality of grid structures 103 in the second structural unit 202 along the first direction; and/or, as shown in FIG. 10, a spacing p1 between the first electrode finger 1021b and the second electrode finger 1022b that are adjacent to each other in the first structural unit 201 is different from a spacing p2 between the first electrode finger 1021b and the second electrode finger 1022b that are adjacent to each other in the second structural unit 202.

It should be noted that "width distribution of the plurality of grid structures 103 in the first structural unit 201 along the first direction is different from width distribution of the plurality of grid structures 103 in the second structural unit 202 along the first direction" may be that, for example, in the plurality of grid structures 103 in the first structural unit 201, the width W of the plurality of grid structures 103 located between the first electrode finger 1021b and the second electrode finger 1022b that are adjacent to each other decrease first and then increase along the first direction X; and in the plurality of grid structures 103 in the second structural unit 202, the width W of the plurality of grid structures 103 located between the first electrode finger 1021b and the second electrode finger 1022b that are adjacent to each other increase first and then decrease along the first direction X. For another example, in the plurality of grid structures 103 in the first structural unit 201, the plurality of grid structures 103 located between the first electrode finger 1021b and the second electrode finger 1022b that are adjacent to each other have a same width W along the first direction X. In the plurality of grid structures 103 in the second structural unit 202, the width W of the plurality of grid structures 103 located between the first electrode finger 1021b and the second electrode finger 1022b that are adjacent to each other decrease first and then increase along the first direction X.

It may be understood that, if the first structural unit 201 is different from the second structural unit 202, the first structural unit 201 and the second structural unit 202 modulate the acoustic wave in different manners.

Because the bulk acoustic wave resonator 10 includes the first structural unit 201 and the second structural unit 202 that are alternately arranged along the first direction X, the bulk acoustic wave resonator 10 has a periodicity along the first direction X. Therefore, an excitation intensity of a main mode of the acoustic wave propagation can be maximized, and a large electromechanical coupling coefficient can be obtained. Based on this, to avoid a spurious mode caused by the same structural units, that is, the structural units that are repeatedly arranged in the acoustic wave resonator 10, the bulk acoustic wave resonator 10 includes the first structural unit 201 and the second structural unit 202, where the first structural unit 201 is different from the second structural unit 202. In this way, the periodicity may be changed, so that an excitation intensity of a high-order spurious mode is reduced. Therefore, the high-order spurious mode can be suppressed or eliminated, and a degree of design freedom is enriched. Based on this, this design can not only obtain the large electromechanical coupling coefficient, but also suppress or eliminate the high-order spurious mode.

Based on this, when the bulk acoustic wave resonator 10 is designed, a point in the bulk acoustic wave resonator 10 is used as an origin. A width and a position of each grid structure 103 are along the first direction X. A function of a distance x from the grid structure 103 to the origin is f_{wn}=f₁(x) and fₗₙ=f₂(x), where f_{wn} is a width of an n^{th} grid, and fₗₙ is a position of the n^{th} grid.

It may be understood that, the bulk acoustic wave resonator 10 may further include a third structural unit. The first structural unit 201, the second structural unit 202, and the third structural unit are alternately arranged along the first direction X, and the first structural unit 201, the second structural unit 202, and the third structural unit are different.

### Embodiment 2

A difference between Embodiment 2 and Embodiment 1 lies in that, compared with Embodiment 1, in Embodiment 2, a dielectric layer is added.

A bulk acoustic wave resonator 10 provided in Embodiment 2 includes a piezoelectric material layer 101, a first comb-shaped electrode 1021, a second comb-shaped electrode 1022, a grid structure 103, and a dielectric layer. For descriptions of the piezoelectric material layer 101, the first comb-shaped electrode 1021, the second comb-shaped electrode 1022, and the grid structure 103, refer to related descriptions in the foregoing Embodiment 1, and details are not described in Embodiment 2 again. Embodiment 2 merely describes a part different from Embodiment 1, that is, merely describes the dielectric layer.

In Embodiment 2, a material of the dielectric layer may include, for example, one or more of silicon oxide, silicon nitride, silicon oxynitride, and aluminum oxide. Silicon oxide may be, for example, silicon dioxide (SiO₂).

For example, the dielectric layer in the bulk acoustic wave resonator 10 may be disposed in the following manners:

First manner: As shown in FIG. 11, the dielectric layer 104 is disposed on sides that are of the first comb-shaped electrode 1021 and the second comb-shaped electrode 1022 and that are away from the piezoelectric material layer 101, and the grid structure 103 is disposed on a side that is of the dielectric layer 104 and that is away from the piezoelectric material layer 101. In this case, when the bulk acoustic wave resonator 10 is manufactured, the piezoelectric material layer 101 may be formed first; the first comb-shaped electrode 1021 and the second comb-shaped electrode 1022 are then formed; the dielectric layer 104 is then formed; and the grid structure 103 is then formed.

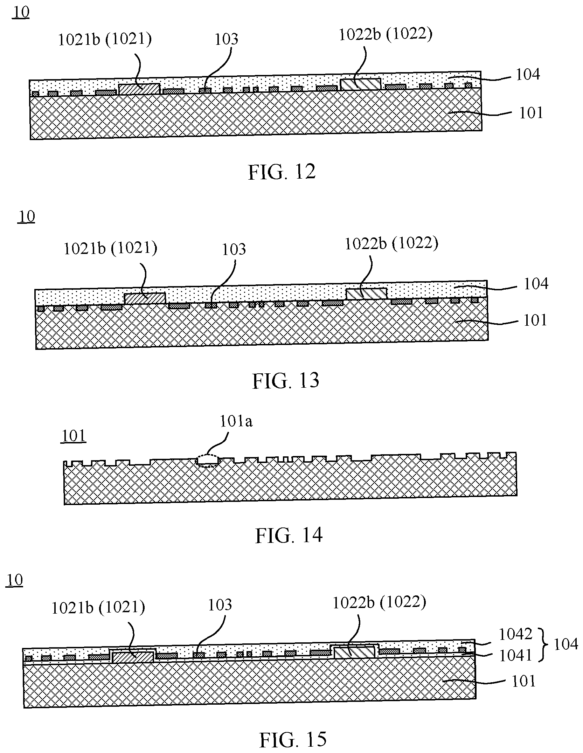

Second manner: As shown in FIG. 12, the dielectric layer 104 is disposed on sides that are of the first comb-shaped electrode 1021, the second comb-shaped electrode 1022, and the grid structure 103 and that are away from the piezoelectric material layer 101, and covers the first comb-shaped electrode 1021, the second comb-shaped electrode 1022, and the grid structure 103. Surfaces of the first comb-shaped electrode 1021 and the second comb-shaped electrode 1022 that are close to the piezoelectric material layer 101 and a surface of the grid structure 103 that is close to the piezoelectric material layer 101 are located on a same plane. In this case, when the bulk acoustic wave resonator 10 is manufactured, the piezoelectric material layer 101 may be formed first; the grid structure 103, the first comb-shaped electrode 1021, and the second comb-shaped electrode 1022 are then formed; and the dielectric layer 104 is then formed. In a process of forming the grid structure 103, the first comb-shaped electrode 1021, and the second comb-shaped electrode 1022, the grid structure 103, the first comb-shaped electrode 1021, and the second comb-shaped electrode 1022 may be formed at the same time; or the grid structure 103 may be formed before the first comb-shaped electrode 1021 and the second comb-shaped electrode 1022; or the first comb-shaped electrode 1021 and the second comb-shaped electrode 1022 may be formed before the grid structure 103.

Third manner: As shown in FIG. 13, the dielectric layer 104 is disposed on sides that are of the first comb-shaped electrode 1021, the second comb-shaped electrode 1022, and the grid structure 103 and that are away from the piezoelectric material layer 101, and covers the first comb-shaped electrode 1021, the second comb-shaped electrode 1022, and the grid structure 103. As shown in FIG. 14, a side of the piezoelectric material layer 101 that is close to the first comb-shaped electrode 1021 includes a groove 101a, and the grid structure 103 is located in the groove 101a. In this case, when the bulk acoustic wave resonator 10 is manufactured, the piezoelectric material layer 101 may be formed first, where the piezoelectric material layer 101 includes a plurality of grooves 101a; the grid structure 103 is then formed in the groove 101a, and the first comb-shaped electrode 1021 and the second comb-shaped electrode 1022 are formed; and the dielectric layer 104 is then formed.

Fourth manner: As shown in FIG. 15, the dielectric layer 104 is disposed on sides that are of the first comb-shaped electrode 1021 and the second comb-shaped electrode 1022 and that are away from the piezoelectric material layer 101, and the grid structure 103 is disposed in the dielectric layer 104. In other words, the dielectric layer 104 includes a first dielectric sublayer 1041 and a second dielectric sublayer 1042 that are stacked. The first dielectric sublayer 1041 and the second dielectric sublayer 1042 are disposed on the sides that are of the first comb-shaped electrode 1021 and the second comb-shaped electrode 1022 and that are away from the piezoelectric material layer 101, and the grid structure 103 is disposed between the first dielectric sublayer 1041 and the second dielectric sublayer 1042.

Based on the foregoing descriptions, the dielectric layer 104 may be disposed in the foregoing four manners. Therefore, the bulk acoustic wave resonator 10 has a high degree of freedom in structural design.

It may be understood that, for the bulk acoustic wave resonator 10, because the acoustic wave mainly propagates in the piezoelectric material layer 101, a shorter distance between the grid structure 103 and the piezoelectric material layer 101 indicates that the grid structure 103 is more sensitive to impact of the acoustic wave, and the grid structure 103 has higher modulation sensitivity. When the dielectric layer 104 is disposed in the third, second, fourth, or first manner, a distance between the grid structure 103 and the piezoelectric material layer 101 gradually increases. When the bulk acoustic wave resonator 10 is designed, the position for disposing the dielectric layer 104 may be selected as required. In addition, when the bulk acoustic wave resonator 10 includes the dielectric layer 104, the dielectric layer 104 may be used for adjusting a resonance frequency of the bulk acoustic wave resonator 10 or serve as a protection layer to protect the grid structure 103, the first comb-shaped electrode 1021, and the second comb-shaped electrode 1022. In addition, when the dielectric layer 104 has a positive temperature coefficient, for example, when the material of the dielectric layer 104 is SiO₂, the dielectric layer 104 has the positive temperature coefficient, and the dielectric layer 104 may further serve as a temperature compensation layer.

### Embodiment 3

A difference between Embodiment 3 and Embodiment 2 lies in that, compared with Embodiment 2, in Embodiment 3, a substrate is added.

A bulk acoustic wave resonator 10 provided in Embodiment 3 includes a piezoelectric material layer 101, a first comb-shaped electrode 1021, a second comb-shaped electrode 1022, a grid structure 103, a dielectric layer 104, and a substrate. For descriptions of the piezoelectric material layer 101, the first comb-shaped electrode 1021, the second comb-shaped electrode 1022, the grid structure 103, and the dielectric layer 104, refer to related descriptions in the foregoing Embodiment 2, and details are not described in Embodiment 3 again. Embodiment 3 merely describes a part different from Embodiment 2, that is, merely describes the substrate.

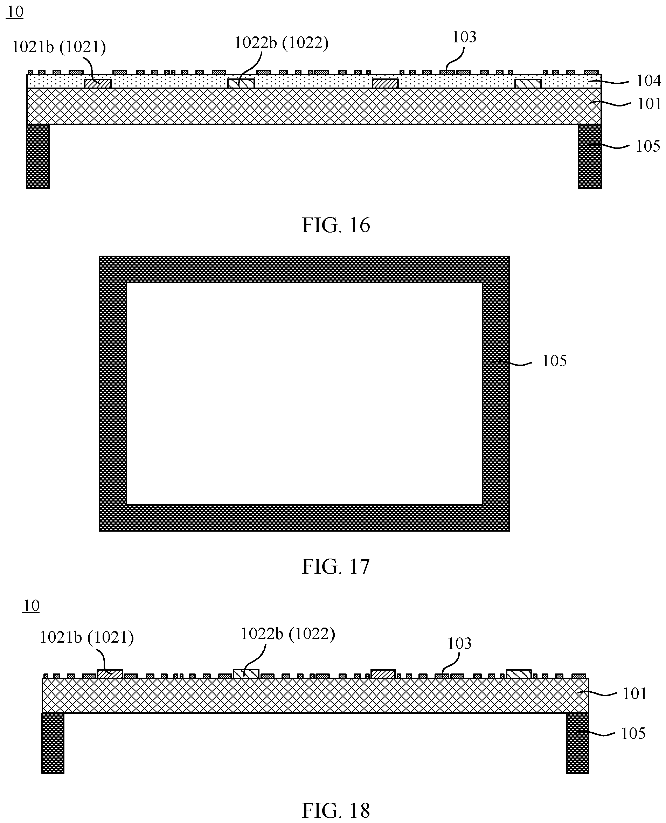

In Embodiment 3, as shown in FIG. 16, the bulk acoustic wave resonator 10 further includes the substrate 105. The substrate 105 is disposed on a side that is of the piezoelectric material layer 101 and that is away from the first comb-shaped electrode 1021 and the second comb-shaped electrode 1022. As shown in FIG. 17, the substrate 105 forms a ring. FIG. 16 is a cross-sectional view of the bulk acoustic wave resonator 10. FIG. 17 is a top view of the substrate 105.

The ring formed by the substrate 105 may be, for example, a circular ring, a square ring, another regular ring, or an irregular ring. It may be understood that a specific ring shape may be designed based on a shape of a graph enclosed by a boundary of the piezoelectric material layer 101.

In some examples, a material of the substrate 105 is a high acoustic velocity material, and the high acoustic velocity material may include, for example, one or more of Si (silicon), SiC (silicon carbide), diamond (diamond), sapphire (sapphire), and AIN (aluminum nitride).

The substrate 105 is disposed in the bulk acoustic wave resonator 10. The substrate 105 may be used for supporting the piezoelectric material layer 101, the first comb-shaped electrode 1021, the second comb-shaped electrode 1022, the grid structure 103, and the dielectric layer 104. Base on this, because the substrate 105 forms a ring, a cavity structure may be formed. In an acoustic wave propagation process, the cavity structure may concentrate energy on the piezoelectric material layer 202, thereby increasing a quality factor of the bulk acoustic wave resonator 10. In addition, the substrate 105 disposed in the bulk acoustic wave resonator 10 may also implement process compatibility. For example, bonding (bonding) between the bulk acoustic wave filter 10 and another electronic component such as an IC component may be implemented by using the substrate 105.

It should be noted that, the bulk acoustic wave resonator 10 provided in Embodiment 3 is described by using an example in which the substrate 105 is added on the bulk acoustic wave resonator 10 provided in Embodiment 2. In some examples, as shown in FIG. 18, the bulk acoustic wave resonator 10 provided in Embodiment 3 may be further added with the substrate 105 based on the bulk acoustic wave resonator 10 provided in Embodiment 1.

### Embodiment 4

A difference between Embodiment 4 and Embodiment 2 lies in that, compared with Embodiment 2, in Embodiment 4, a support layer and a reflection layer are added.

A bulk acoustic wave resonator 10 provided in Embodiment 4 includes a piezoelectric material layer 101, a first comb-shaped electrode 1021, a second comb-shaped electrode 1022, a grid structure 103, a dielectric layer 104, a support layer, and a reflection layer. For descriptions of the piezoelectric material layer 101, the first comb-shaped electrode 1021, the second comb-shaped electrode 1022, the grid structure 103, and the dielectric layer 104, refer to related descriptions in Embodiment 2, and details are not described in Embodiment 4 again. Embodiment 4 merely describes parts different from Embodiment 2, that is, merely describes the support layer and the reflection layer.

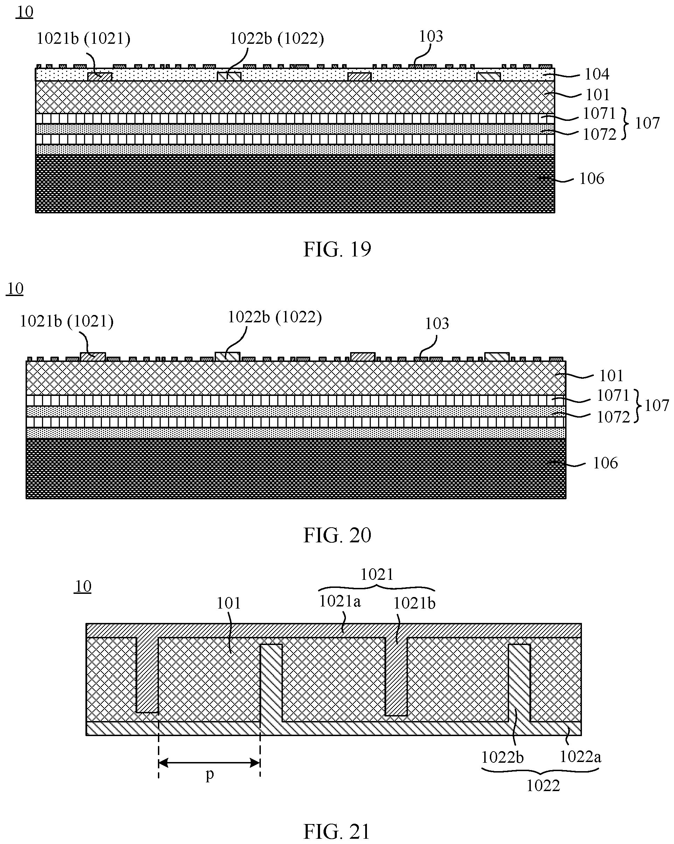

In Embodiment 4, as shown in FIG. 19, the bulk acoustic wave resonator 10 further includes the support layer 106 and the reflection layer 107 that are disposed in a stacked manner. The reflection layer 107 is disposed between the support layer 106 and the piezoelectric material layer 101. The reflection layer 107 includes a first acoustic impedance layer 1071 and a second acoustic impedance layer 1072 that are alternately disposed in a stacked manner, and acoustic impedance of the first acoustic impedance layer 1071 is different from acoustic impedance of the second acoustic impedance layer 1072.

A quantity of first acoustic impedance layers 1071 and second acoustic impedance layers 1072 that are disposed in the reflection layer 107 is not limited, and may be disposed as required. The quantity of first acoustic impedance layers 1071 may be the same as or different from the quantity of second acoustic impedance layers 1072. In addition, the first acoustic impedance layer 1071 or the second acoustic impedance layer 1072 in the reflection layer 107 may be closest to the piezoelectric material layer 101. Similarly the first acoustic impedance layer 1071 or the second acoustic impedance layer 1072 in the reflection layer 107 may be closest to the support layer 106.

In Embodiment 4, the bulk acoustic wave resonator 10 includes the reflection layer 107. Because the reflection layer 107 may reflect an acoustic wave to the piezoelectric material layer 101, energy may be concentrated on the piezoelectric material layer 101 in an acoustic wave propagation process. This can increase a quality factor of the bulk acoustic wave resonator 10.

In addition, the support layer 106 in the bulk acoustic wave resonator 10 is used for supporting the reflection layer 107, the piezoelectric material layer 101, the first comb-shaped electrode 1021, the second comb-shaped electrode 1022, the grid structure 103, and the dielectric layer 104. In some examples, a material of the support layer 106 is a high acoustic velocity material, and the high acoustic velocity material may include, for example, one or more of Si, SiC, diamond, sapphire, and AlN. Based on this, the support layer 106 in the bulk acoustic wave resonator 10 may also implement process compatibility. For example, bonding between the bulk acoustic wave filter 10 and another electronic component such as an IC component may be implemented by using the support layer 106.

It should be noted that, the bulk acoustic wave resonator 10 provided in Embodiment 4 is described by using an example in which the support layer 106 and the reflection layer 107 are added on the bulk acoustic wave resonator 10 provided in Embodiment 2. In some examples, as shown in FIG. 20, the bulk acoustic wave resonator 10 provided in Embodiment 4 may further be added with the support layer 106 and the reflection layer 107 based on the bulk acoustic wave resonator 10 provided in Embodiment 1.

With the development of mobile communication and users' increasing demands for communication speeds, more frequency bands are used in a mobile communication system. As an important frequency band of a 5G communication system, N77 and N79 have characteristics such as a high operating frequency and a large bandwidth. In particular, an operating frequency band of the N77 frequency band is 3300 MHz to 4200 MHz, and a bandwidth ratio is 24%. Because the bandwidth ratio of the N77 frequency band is 24%, the bulk acoustic wave resonator that forms the filter needs to have an electromechanical coupling coefficient of more than 25% to satisfy a bandwidth requirement of the bulk acoustic wave resonator. However, a current electromechanical coupling coefficient of the bulk acoustic wave resonator cannot satisfy the requirement. A related technology introduces that the bulk acoustic wave resonator may have an electromechanical coupling coefficient of about 25% by exciting an A1 Lamb wave on the ZY-LiNbO₃ piezoelectric sheet shown in FIG. 1. FIG. 2 shows an admittance curve that corresponds to the bulk acoustic wave resonator shown in FIG. 1 and that is obtained through simulation. Based on the admittance curve shown in FIG. 2, a resonance frequency and an anti-resonance frequency of the bulk acoustic wave resonator are respectively 4840 MHz and 5480 MHz, and an electromechanical coupling coefficient of the bulk acoustic wave resonator 10 obtained through calculation is 25.7%. Although the electromechanical coupling coefficient of the bulk acoustic wave resonator obtained through simulation may reach 25.7%, an actual electromechanical coupling coefficient of the bulk acoustic wave resonator is lower than a simulation value, that is, lower than 25%. As a result, the filter is not suitable for the N77 frequency band.

To resolve a problem that an electromechanical coupling coefficient of the bulk acoustic wave resonator 10 is small, Embodiment 5 and Embodiment 6 of this application further provide the following two bulk acoustic wave resonators 10.

### Embodiment 5

Because an operating principle of the bulk acoustic wave resonator is that an A1 Lamb wave is excited by using a piezoelectric material layer 101, and whether the A1 Lamb wave is excited is related to a piezoelectric coefficient e₁₅ of the piezoelectric material layer 101, the piezoelectric coefficient e₁₅ of the piezoelectric material layer 101 has a decisive effect on an electromechanical coupling coefficient of the bulk acoustic wave resonator. A material of the piezoelectric material layer 101, for example, LiNbO₃ or LiTaO₃, is generally an anisotropic material. A basic characteristic of the anisotropic material is closely related to Euler angles (α, β, γ) of the material. The Euler angles are a group of three independent angle parameters used to determine a position of a fixed-point rotation rigid body, including a nutation angle α, a rotation angle (which may also be referred to as a precession angle) β, and an intrinsic rotation angle γ. In other words, the Euler angles (α, β, γ) of the piezoelectric material layer 101 affect the piezoelectric coefficient e₁₅ of the piezoelectric material layer 101, and further affect the electromechanical coupling coefficient of the bulk acoustic wave resonator.

Based on the foregoing descriptions, the bulk acoustic wave resonator 10 provided in Embodiment 5 includes, as shown in FIG. 21, a piezoelectric material layer 101, a first comb-shaped electrode 1021, and a second comb-shaped electrode 1022, where the Euler angles (α, β, γ) of the piezoelectric material layer 101 satisfy the following conditions: -10°<α<10°, -10°<γ<10°, and 18°<β<48°.

For descriptions of structures and positions for disposing the piezoelectric material layer 101, the first comb-shaped electrode 1021, and the second comb-shaped electrode 1022, refer to Embodiment 1, and details are not described herein again.

In addition, the material of the piezoelectric material layer 101 may include one or more of LiNbO₃ (lithium niobate), LiTaO₃ (lithium tantalate), and the like.

In some examples, the bulk acoustic wave resonator 10 may further include one or more of a grid structure 103, a dielectric layer 104, a substrate 105, a reflection layer 107, and a support layer 106. In other words, a structure of the bulk acoustic wave resonator 10 provided in Embodiment 5 may also be the same as a structure of the bulk acoustic wave resonator 10 provided in Embodiment 1, Embodiment 2, Embodiment 3, and Embodiment 4. For details, refer to the structure of the bulk acoustic wave resonator 10 provided in Embodiment 1, Embodiment 2, Embodiment 3, and Embodiment 4. Details are not described herein again.

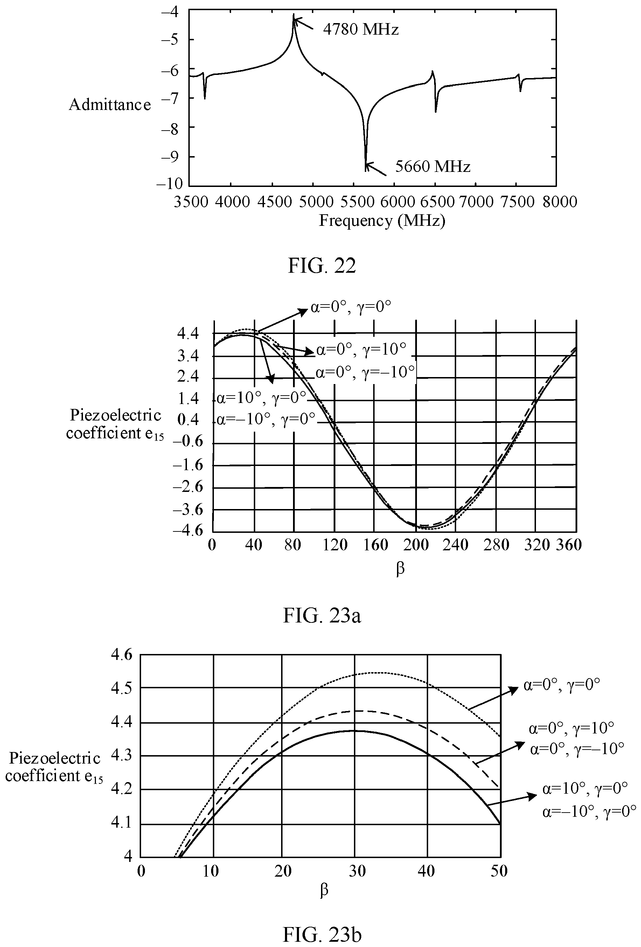

It can be learned through simulation calculation that, when α=γ=0° and β=33°, the piezoelectric coefficient e₁₅ of the piezoelectric material layer 101 is a maximum value, the material of the piezoelectric material layer 101 is LiNbO₃, and Euler angles (α, β, γ) of LiNbO₃ satisfy a condition of α=γ=0° and β=33°, that is, a cut shape of LiNbO₃ is (0°, 33°, 0°). In this case, FIG. 22 shows an admittance curve corresponding to the bulk acoustic wave resonator 10 shown in FIG. 21. With reference to FIG. 22, it can be learned through calculation that the electromechanical coupling coefficient of the bulk acoustic wave resonator 10 is increased to 33%. In addition, a spurious mode in FIG. 22 is weakened compared with that in FIG. 2.

FIG. 23a shows a diagram of a variation relationship between a piezoelectric coefficient e₁₅ and β under different α and γ. Specifically, in a first manner, α=0° and γ=0°; in a second manner, α=10° and γ=0°; in a third manner, α=-10° and γ=0°; in a fourth manner, α=0° and γ=-10°; and in a fifth manner, α=0° and γ=10°. Curve charts in the second and third manners overlap, and curve charts in the fourth and fifth manners overlap. FIG. 23b is a partial enlarged view of FIG. 23a.

When α=±10° or γ=±10°, a variation relationship between the piezoelectric coefficient e₁₅ and β is slightly different from a result obtained when α=γ=0°. Therefore, it can be learned from FIG. 23b that when α=±10° or γ=±10°, and 18°<β<48°, the piezoelectric material layer 101 has a large piezoelectric coefficient e₁₅.

It can be learned from the foregoing descriptions that, when the Euler angles (α, β, γ) of the piezoelectric material layer 101 satisfy the following conditions: -10°<α<10°, -10°<γ<10°, and 18°<β<48°, the piezoelectric material layer 101 has a large piezoelectric coefficient e₁₅, so that the electromechanical coupling coefficient of the bulk acoustic wave resonator 10 may be large.

### Embodiment 6

A bulk acoustic wave resonator 10 provided in Embodiment 6 is shown in FIG. 21, and includes a piezoelectric material layer 101, a first comb-shaped electrode 1021, and a second comb-shaped electrode 1022. The first comb-shaped electrode 1021 is disposed on the piezoelectric material layer 101. The first comb-shaped electrode 1021 includes a first busbar 1021a and a plurality of first electrode fingers 1021b sequentially arranged along an extension direction of the first busbar 1021a. The plurality of first electrode fingers 1021b are all electrically connected to the first busbar 1021a, and the plurality of first electrode fingers 1021b do not contact each other. The second comb-shaped electrode 1022 is disposed on the piezoelectric material layer 101. The second comb-shaped electrode 1022 includes a second busbar 1022a and a plurality of second electrode fingers 1022b sequentially arranged along an extension direction of the second busbar 1022a. The plurality of second electrode fingers 1022b are all electrically connected to the second busbar 1022a, and the plurality of second electrode fingers 1022b do not contact each other. The plurality of first electrode fingers 1021b in the first comb-shaped electrode 1021 and the plurality of second electrode fingers 1022b in the second comb-shaped electrode 1022 are arranged at spacings and do not contact each other. A spacing between the first electrode finger 1021b and the second electrode finger 1022b that are adjacent to each other is p.

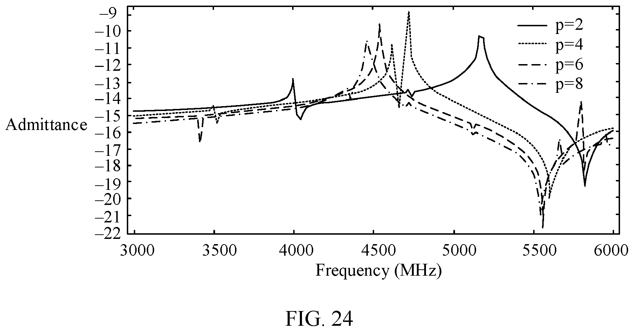

FIG. 24 is an admittance curve diagram corresponding to different spacings p (where p is 2, 4, 6, or 8) in the bulk acoustic wave resonator shown in FIG. 21. It can be learned from admittance curves corresponding to different spacings p shown in FIG. 24 that the spacing p between the first electrode finger 1021b and the second electrode finger 1022b that are adjacent to each other affects an electromechanical coupling coefficient of the bulk acoustic wave resonator 10. The electromechanical coupling coefficient of the bulk acoustic wave resonator 10 increases as the spacing p between the first electrode finger 1021b and the second electrode finger 1022b that are adjacent to each other increases, and finally converges. Therefore, the electromechanical coupling coefficient of the bulk acoustic wave resonator 10 may be adjusted by changing the spacing p between the first electrode finger 1021b and the second electrode finger 1022b that are adjacent to each other.

Based on the foregoing descriptions, in Embodiment 6, a range of the spacing p between the first electrode finger 1021b and the second electrode finger 1022b that are adjacent to each other is 2 µm≤p≤12.5 µm, and p is not equal to 3 µm and 5 µm. When the range of the spacing p between the first electrode finger 1021b and the second electrode finger 1022b that are adjacent to each other is 2 µm≤p≤12.5 µm, a regulation range of the electromechanical coupling coefficient of the bulk acoustic wave resonator 10 is large, and the electromechanical coupling coefficient of the bulk acoustic wave resonator 10 may be large by modulating p, to satisfy requirements of some bulk acoustic wave resonators 10.

For example, the spacing p between the first electrode finger 1021b and the second electrode finger 1022b that are adjacent to each other may be 2 µm, 4 µm, 6 µm, 10 µm, 12.5 µm, or the like.

A range of a length λ of a structural unit 200, a first structural unit 201, and a second structural unit 202 along a first direction X may be 4 µm≤λ≤25 µm, where λ=2p.

Based on this, because the electromechanical coupling coefficient of the bulk acoustic wave resonator 10 is related to a passband of a filter, and changes as a passband of the bulk acoustic wave resonator 10 changes, the spacing p between the first electrode finger 1021b and the second electrode finger 1022b that are adjacent to each other may be designed based on the change of the passband of the filter. In other words, when the filter is designed, the electromechanical coupling coefficient of the bulk acoustic wave resonator 10 may be determined based on the passband of the filter, and then the spacing p between the first electrode finger 1021b and the second electrode finger 1022b that are adjacent to each other is adjusted based on the electromechanical coupling coefficient of the bulk acoustic wave resonator 10.

For descriptions of a material of the piezoelectric material layer 101, refer to Embodiment 1, and details are not described herein again.

In some examples, the bulk acoustic wave resonator 10 may further include one or more of a grid structure 103, a dielectric layer 104, a substrate 105, a reflection layer 107, and a support layer 106. In other words, a structure of the bulk acoustic wave resonator 10 provided in Embodiment 6 may also be the same as a structure of the bulk acoustic wave resonator 10 provided in Embodiment 1, Embodiment 2, Embodiment 3, Embodiment 4, and Embodiment 5. For details, refer to the structure of the bulk acoustic wave resonator 10 provided in Embodiment 1, Embodiment 2, Embodiment 3, Embodiment 4, and Embodiment 5. Details are not described herein again.

An embodiment of this application further provides an electronic device. The electronic device includes a filter, a processor, and a circuit board. Both the filter and the processor are disposed on the circuit board. The filter may be the filter provided above.

The circuit board may be a printed circuit board (printed circuit board, PCB).

The electronic device may be, for example, different types of user equipment or terminal devices such as a mobile phone (mobile phone), a tablet computer (pad), a personal digital assistant (personal digital assistant, PDA), a television, an intelligent wearable product (for example, a smartwatch or a smart band), a virtual reality (virtual reality, VR) terminal device, an augmented reality (augmented reality, AR) terminal device, a small rechargeable household appliance (for example, a soy milk machine or a floor sweeping robot), an uncrewed aerial vehicle, radar, an aerospace device, and an in-vehicle device. A specific form of the electronic device is not specially limited in this embodiment of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A bulk acoustic wave resonator, comprising:
a piezoelectric material layer;
a first comb-shaped electrode, disposed on the piezoelectric material layer, and comprising a first busbar and a plurality of first electrode fingers sequentially arranged along an extension direction of the first busbar;
a second comb-shaped electrode, disposed on the piezoelectric material layer, and comprising a second busbar and a plurality of second electrode fingers sequentially arranged along an extension direction of the second busbar, wherein the plurality of first electrode fingers and the plurality of second electrode fingers are arranged at spacings and do not contact each other; and
at least one grid structure, disposed at least between the first electrode finger and the second electrode finger, and configured to suppress excitation of a high-order mode when an acoustic wave propagates along a first direction.

2. The bulk acoustic wave resonator according to claim 1, wherein the at least one grid structure comprises a plurality of grid structures arranged along the first direction, wherein
the first direction is a direction in which the plurality of first electrode fingers and the plurality of second electrode fingers are arranged at spacings.

3. The bulk acoustic wave resonator according to claim 2, wherein widths of the plurality of grid structures along the first direction are not exactly the same.

4. The bulk acoustic wave resonator according to claim 3, wherein the plurality of grid structures are disposed between at least one pair of the first electrode finger and the second electrode finger that are adjacent to each other, and the widths of the plurality of grid structures located between the first electrode finger and the second electrode finger that are adjacent to each other along the first direction satisfy one of the following conditions:
the widths of the plurality of grid structures decrease first and then increase, or increase first and then decrease, or gradually increase in a direction approaching the first electrode finger from a middle of the first electrode finger and the second electrode finger, and gradually decrease in a direction of approaching the second electrode finger.

5. The bulk acoustic wave resonator according to claim 3, wherein the plurality of grid structures are disposed between at least one pair of the first electrode finger and the second electrode finger that are adjacent to each other, and the plurality of grid structures located between the first electrode finger and the second electrode finger that are adjacent to each other comprise a first grid structure and a second grid structure that are alternately arranged, wherein
a width of the first grid structure along the first direction is different from a width of the second grid structure along the first direction.

6. The bulk acoustic wave resonator according to any one of claims 2 to 5, wherein the bulk acoustic wave resonator comprises a plurality of same structural units arranged along the first direction, wherein
the structural unit comprises at least one first electrode finger, at least one second electrode finger, and the grid structure disposed at least between the first electrode finger and the second electrode finger.

7. The bulk acoustic wave resonator according to any one of claims 2 to 5, wherein the bulk acoustic wave resonator comprises a first structural unit and a second structural unit that are alternately arranged along the first direction; and
the first structural unit and the second structural unit each comprise at least one first electrode finger, at least one second electrode finger, and the grid structure disposed at least between the first electrode finger and the second electrode finger, wherein
width distribution of the plurality of grid structures in the first structural unit along the first direction is different from width distribution of the plurality of grid structures in the second structural unit along the first direction; and/or
a spacing between the first electrode finger and the second electrode finger that are adjacent to each other in the first structural unit is different from a spacing between the first electrode finger and the second electrode finger that are adjacent to each other in the second structural unit.

8. The bulk acoustic wave resonator according to any one of claims 1 to 7, wherein a range of a spacing p between the first electrode finger and the second electrode finger that are adjacent to each other is 2 µm≤p≤12.5 µm, and p is not equal to 3 µm and 5 µm.

9. The bulk acoustic wave resonator according to any one of claims 1 to 8, wherein Euler angles (α, β, γ) of the piezoelectric material layer satisfy the following conditions: -10°<α<10°, -10°<γ<10°, and 18°<β<48°.

10. The bulk acoustic wave resonator according to claim 9, wherein a material of the piezoelectric material layer comprises lithium niobate and/or lithium tantalate.

11. The bulk acoustic wave resonator according to any one of claims 1 to 10, wherein the bulk acoustic wave resonator further comprises a dielectric layer, and the dielectric layer is disposed on sides that are of the first comb-shaped electrode and the second comb-shaped electrode and that are away from the piezoelectric material layer, and the grid structure is disposed on a side that is of the dielectric layer and that is away from the piezoelectric material layer.

12. The bulk acoustic wave resonator according to any one of claims 1 to 10, wherein the bulk acoustic wave resonator further comprises a dielectric layer, and the dielectric layer is disposed on sides that are of the first comb-shaped electrode, the second comb-shaped electrode, and the grid structure and that are away from the piezoelectric material layer, and covers the first comb-shaped electrode, the second comb-shaped electrode, and the grid structure.

13. The bulk acoustic wave resonator according to claim 12, wherein surfaces of the first comb-shaped electrode and the second comb-shaped electrode that are close to the piezoelectric material layer and a surface of the grid structure that is close to the piezoelectric material layer are located on a same plane; or
a side of the piezoelectric material layer that is close to the first comb-shaped electrode comprises a groove, and the grid structure is located in the groove.

14. The bulk acoustic wave resonator according to any one of claims 1 to 10, wherein the bulk acoustic wave resonator further comprises a dielectric layer; and
the dielectric layer is disposed on sides that are of the first comb-shaped electrode and the second comb-shaped electrode and that are away from the piezoelectric material layer, and the grid structure is disposed in the dielectric layer.

15. The bulk acoustic wave resonator according to any one of claims 1 to 14, wherein the bulk acoustic wave resonator further comprises a substrate, the substrate is disposed on a side that is of the piezoelectric material layer and that is away from the first comb-shaped electrode and the second comb-shaped electrode, and the substrate forms a ring.

16. The bulk acoustic wave resonator according to any one of claims 1 to 14, wherein the bulk acoustic wave resonator further comprises a support layer and a reflection layer that are disposed in a stacked manner, and the reflection layer is disposed between the support layer and the piezoelectric material layer, wherein
the reflection layer comprises a first acoustic impedance layer and a second acoustic impedance layer that are alternately disposed in a stacked manner, and acoustic impedance of the first acoustic impedance layer is different from acoustic impedance of the second acoustic impedance layer.

17. The bulk acoustic wave resonator according to any one of claims 1 to 16, wherein the grid structure is in a strip shape; and
an extension direction of the grid structure is the same as an extension direction of the first electrode finger and the second electrode finger.

18. A bulk acoustic wave resonator, comprising:
a piezoelectric material layer;
a first comb-shaped electrode, disposed on the piezoelectric material layer, and comprising a first busbar and a plurality of first electrode fingers sequentially arranged along an extension direction of the first busbar;
a second comb-shaped electrode, disposed on the piezoelectric material layer, and comprising a second busbar and a plurality of second electrode fingers sequentially arranged along an extension direction of the second busbar, wherein the first electrode finger and the second electrode finger are arranged at spacings and do not contact each other; and
Euler angles (α, β, γ) of the piezoelectric material layer satisfy the following conditions: -10°<α<10°, - 10°<γ<10°, and 18°<β<48°.

19. A bulk acoustic wave resonator, comprising:
a piezoelectric material layer;
a first comb-shaped electrode, disposed on the piezoelectric material layer, and comprising a first busbar and a plurality of first electrode fingers sequentially arranged along an extension direction of the first busbar;
a second comb-shaped electrode, disposed on the piezoelectric material layer, and comprising a second busbar and a plurality of second electrode fingers sequentially arranged along an extension direction of the second busbar, wherein the first electrode finger and the second electrode finger are arranged at spacings and do not contact each other; and
a range of a spacing p between the first electrode finger and the second electrode finger that are adjacent to each other is 2 µm≤p≤12.5 µm, and p is not equal to 3 µm and 5 µm.

20. A filter, comprising a plurality of cascaded bulk acoustic wave resonators, wherein the bulk acoustic wave resonator is the bulk acoustic wave resonator according to any one of claims 1 to 19.

21. An electronic device, comprising a filter, a processor, and a circuit board, wherein both the filter and the processor are disposed on the circuit board; and
the filter is the filter according to claim 20.
